## Europäisches Patentamt
## European Patent Office
## Office européen des brevets

(19)

(11) Veröffentlichungsnummer: **0 129 695**
**B1**

(12) # EUROPÄISCHE PATENTSCHRIFT

(45) Veröffentlichungstag der Patentschrift:
**02.09.87**

(51) Int. Cl.⁴: **H 05 K 7/18,** H 02 B 1/08

(21) Anmeldenummer: **84105557.7**

(22) Anmeldetag: **16.05.84**

(54) **Bausystem für ein Gestell der Vertikalbauweise.**

(30) Priorität: **28.06.83 CH 3527/83**

(43) Veröffentlichungstag der Anmeldung:
**02.01.85 Patentblatt 85/1**

(45) Bekanntmachung des Hinweises auf die Patenterteilung:
**02.09.87 Patentblatt 87/36**

(84) Benannte Vertragsstaaten:
**CH DE FR GB IT LI NL SE**

(56) Entgegenhaltungen:
**DE-A-2 740 971**
**FR-A-1 307 481**
**FR-A-1 307 807**
**FR-A-1 559 266**
**US-A-3 066 244**

**ELEKTROTECHNISCHE ZEITSCHRIFT ETZ, Band 101, Nr. 6, März 1980, Seiten 410-412, Berlin, DE; "Aluminium für Elektronik-Zubehör"**

(73) Patentinhaber: **CONTRAVES AG,**
**Schaffhauserstrasse 580, CH- 8052 Zürich (CH)**

(72) Erfinder: **Kuster, Manfred, Rietgrabenstrasse 7,**
**CH- 8152 Opfikon (CH)**
Erfinder: **Weiss, Paul, Risweg 345, CH- 4624**
**Härkingen (CH)**

**Beschreibung**

Die Erfindung betrifft ein Bausystem für ein gehäuseartig ausgebildetes Gestell der Vertikalbauweise zur Aufnahme elektronischer Geräteeinheiten die in übereinanderliegenden Verdrahtungsebenen über Stecker mit entsprechend zugeführten, verkabelten Aussenleitungen der Nachrichten- und anderen Signal- und Stromversorgung verbindbar sind, wie es beispielsweise bekannt ist aus FR-A- 1 307 807.

Derartige Gestelle zur Aufnahme in mehreren Etagen übereinanderliegend angeordneter, elektronischer Geräteeinheiten sind in vielfältigen Ausführungsformen bekannt. Die zunehmende Komplexität und die höhere Integrationsdichte der elektronischen Geräteeinheiten bringen es mit sich, dass sich die Anzahl externer und interner Kabel und Stecker entsprechend erhöhen und somit die Geräteeinheiten und Gestelle unter Berücksichtigung der Standardisierung entsprechend auszubilden sind, wobei ein bevorzugtes, auf die Breite der Geräteeinheiten bezogenes Mass die 19-Zoll-Bauweise ist.

Der Erfindung liegt die Aufgabe zugrunde, ein gehäuseartig ausgebildetes Gestell so abzuwandeln und ein Bausystem anzugeben, bei dem eine gute Zugänglichkeit und mehr Raum als bisher für die Verdrahtung der Kabel zur Verfügung stehen.

Gemäss der Erfindung wird diese Aufgabe dadurch gelöst, dass das Gestell baukastenartig aus einer Rückwand als erste Baueinheit und einem Rahmen als zweite Baueinheit ausgebildet ist, wobei

- die Rückwand kastenartig und zur Aufnahme der Verdrahtung mit einem Hohlraum ausgebildet ist, auf der dem Rahmen zugewandten Stirnseite mit einer Ausnehmung weitgehend offen gestaltet und in den einzelnen Verdrahtungsebenen mit je einem Trägerorgan für das mit Steckern versehene Kabel und neben der Ausnehmung für den Anschluss der Aussenleitungen mit Steckerorganen versehen ist,

- der Rahmen an der Stirnseite der Rückwand lösbar befestigt ist und innenseitig mehrere Gleit- und/oder Auszugsschienen für die Geräteeinheiten aufweist, und

- in zusammengebautem Zustand der beiden Baueinheiten die Steckerorgane stirnseitig frei zugänglich an der Rückwand des Gestells angeordnet sind.

Das Bausystem zeichnet sich durch eine montagefreundliche Zugänglichkeit der externen Steckerorgane und internen Stecker, der Verdrahtung der Aussenleitungen in der Rückwand, durch die Kabelführung zu den Geräteeinheiten sowie durch eine relativ geringe Stellfläche aus. Dieses ist deshalb möglich, weil einerseits die Rückwand als getrennte Baueinheit für sich allein verdrahtet und geprüft werden kann und andererseits die externen Steckerorgane frei zugänglich an der Rückwand des Gestells angeordnet sind. Auch ist bei diesem Bausystem eine nachträgliche Erweiterung der Verdrahtung nach Entfernen der Geräteeinheiten ohne besonderen Aufwand möglich.

Die freizugängliche Anordnung der externen Steckerorgane ermöglicht eine Zuführung der Aussenleitungen von der Decke und/oder vom Boden, wobei insbesondere bei engen Raumverhältnissen die Gestelle kontaktierend in Reihe aufgestellt werden können.

Weitere Merkmale der Erfindung ergeben sich aus der folgenden Beschreibung in Verbindung mit der Zeichnung und den Patentansprüchen.

Die Erfindung wird nachstehend anhand eines Ausführungsbeispiels unter Bezugnahme auf die Zeichnung beschrieben.

Es zeigt:

Fig. 1 eine perspektivische Explosionsdarstellung eines Gestells der Vertikalbauweise zur Aufnahme elektronischer Geräteeinheiten,

Fig. 2 das schematisch und in Seitenansicht dargestellte Gestell mit dem Verkabelungskonzept,

Fig. 3 einen Schnitt gemäss der Linie III-III in Fig. 2 und

Fig. 4 einen Schnitt gemäss der Linie IV-IV in Fig. 3.

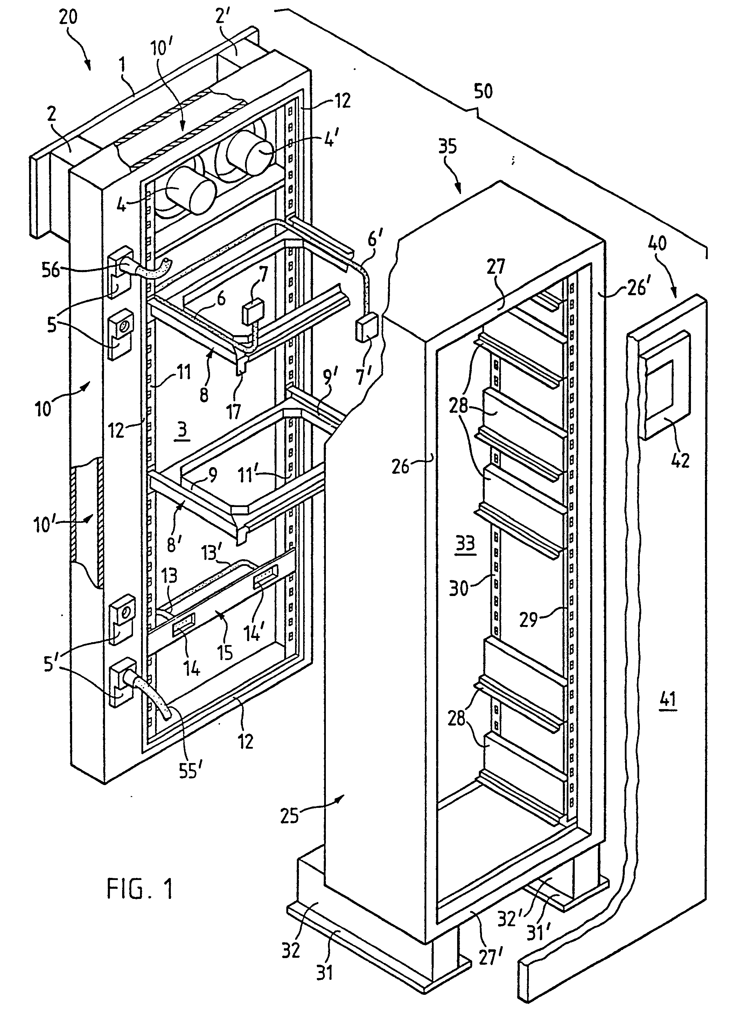

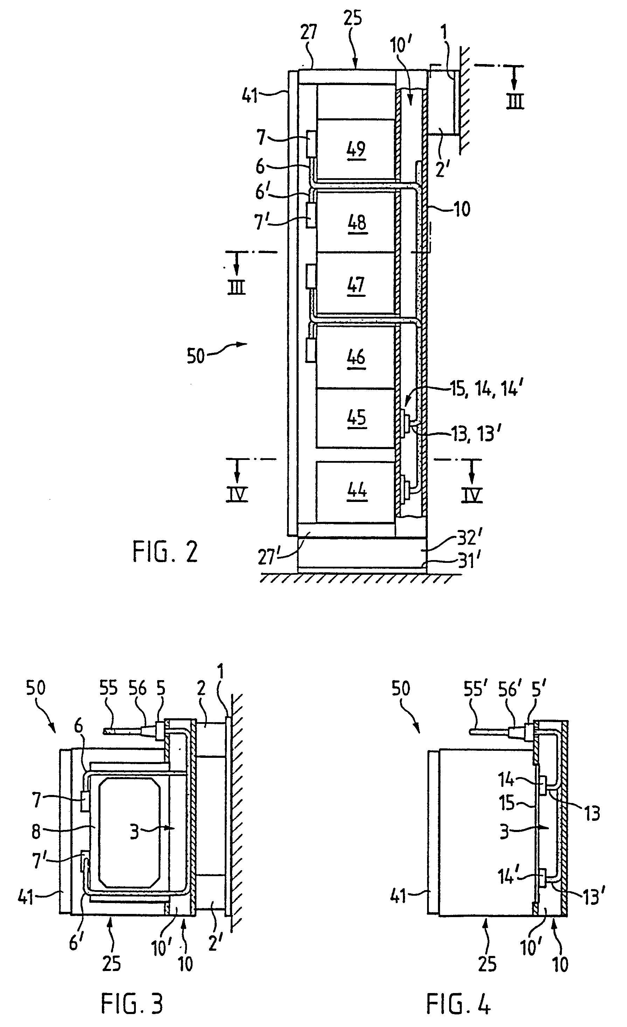

In Fig. 1 ist in Explosionsdarstellung das Bausystem für ein in seiner Gesamtheit mit 50 bezeichnetes Gestell der Vertikalbauweise dargestellt, welches, wie in Fig. 2 schematisch dargestellt, zur Halterung übereinanderliegend angeordneter elektronischer Geräteeinheiten 44, 45, 46, 47, 48 und 49 ausgebildet ist. Das baukastenartig ausgebildete Gestell 50 umfasst im wesentlichen eine erste Baueinheit 20, eine zweite Baueinheit 35 sowie eine dritte Baueinheit 40, die nachstehend im Einzelnen beschrieben werden.

Die erste Baueinheit 20 nach Fig. 1 ist als kastenartige Rückwand 10 ausgebildet, welche als Nahtstelle zwischen externer und interner Verdrahtung von entsprechend zugeführten Aussenleitungen 55, 55' der Nachrichten- und anderen Signal- und Stromversorgung dient. An der Rückwand 10 sind stirnseitig, vorzugsweise seitlich übereinanderliegend angeordnete Steckerorgane 5, 5' vorgesehen. Die im Hohlraum 10' der Rückwand 10 angeordnete, nicht näher dargestellte Verdrahtung ist in mehrere, übereinanderliegend angeordnete Verdrahtungsebenen unterteilt und wird jeweils als gebündeltes Kabel 6, 6' beziehungsweise 13, 13' einem entsprechend ausgebildeten Trägerorgan zugeführt.

Das einzelne Trägerorgan kann entweder als ein in der Verdrahtungsebene angeordneter Tragrahmen 8, 8' oder aber als Traverse 15 ausgebildet sein, welche jeweils weitgehend stufenlos höhenverstellbar an entsprechend mit Einstecklöchern versehenen Tragleisten 11, 11' der Rückwand 10 einsteckbar sind. Bei Verwendung von Tragrahmen 8, 8' wird das an dem einen Ende mit einem Stecker 7, 7' versehene Kabel 6, 6' jeweils in einem Kanal 9, 9' des Tragrahmens 8, 8' nach vorne geführt. Bei Verwendung von Traversen 15, wobei in Fig. 1 nur eine dargestellt ist, wird das Kabel 13, 13' jeweils auf eine in der Traverse 15 vorgesehene, schematisch dargestellte Steckerbuchse 14, 14' geführt.

Für die Belüftung und Kühlung des Gestells 50 sind zwei im Hohlraum 10' der kastenartig ausgebildeten Rückwand 10 integrierte Ventilatoren 4, 4' vorgesehen. An der Rückseite der Rückwand 10 sind zwei, im oberen Bereich und im Abstand zueinander an einem Träger 1 angeordnete, schematisch dargestellte Schwingelemente 2, 2' vorgesehen, welche der Verminderung von Vibrationen und Stössen dienen.

Die kastenartig ausgebildete Rückwand 10 ist stirnseitig weitgehend offen, mit einer Ausnehmung 3 zum Durchführen der Kabel 6, 6' oder 13, 13' versehen und weist ferner eine umlaufende, nicht näher dargestellte Nut auf, die zur aufnahme einer Dichtung 12 (EMV-Dichtung) ausgebildet ist.

Die zweite Baueinheit 35 nach Fig. 1 umfasst einen im wesentlichen aus zwei Seitenwänden 26, 26', einem oberen Boden 27 und einem unteren Boden 27' gebildeten Rahmen 25. Der den Raum 33 bildende Rahmen 25 ist, wie bekannt, innenseitig mit mehreren Gleitschienen 28 zur Aufnahme von Geräteeinheiten (Fig. 2) ausgestattet, wobei in Fig. 1 nur die innenseitig an der einen Seitenwand 26' angeordneten Gleitschienen 28 sichtbar sind. Korrespondierend zu den an der Seitenwand 26' angeordneten Gleitschienen 28 sind an der Innenseite der Seitenwand 26 ebenfalls entsprechende Gleitschienen vorgesehen. Die an den Seitenwänden 26, 26' korrespondierend zueinander angeordneten Gleitschienen 28 sind an entsprechend zugeordneten mit Einstecklöchern versehenen Tragleisten 29, 30 einsteckbar und weitgehend stufenlos höhenverstellbar. Der Rahmen 25 ist mit zwei im Abstand zueinander angeordneten, schematisch dargestellten Schwingelementen 32, 32' und Fussplatten 31, 31' ausgestattet, welche in nicht näher dargestellter Weise an der Unterseite des Rahmens 25 befestigt sind.

Die dritte, als Tür 41 ausgebildete Baueinheit 40 bildet den stirnseitigen Abschluss des Gestells 50 und ist, wie bereits bekannt, mit nicht näher dargestellten Gelenkelementen an dem Rahmen 25 angelenkt. Die Gelenkelemente sind vorzugsweise als Türarretierung ausgebildet, welche ein unbeabsichtigtes Zufallen der offenstehenden Tür 41 verhindert.

In Fig. 2 ist in geschnittener Seitenansicht das in dem Gestell 50 angeordnete Verkabelungskonzept schematisch dargestellt und man erkennt die übereinanderliegend in dem Rahmen 25 angeordneten Geräteeinheiten 44, 45, 46, 47, 48 und 49, die Tür 41 sowie die Rückwand 10. Im oberen Bereich ist als erstes Ausführungsbeispiel das Kabel 6, 6' aus dem Hohlraum 10' bis nach vorne geführt und mit dem Stecker 7, 7' an den beiden zugeordneten Geräteeinheiten 48, 49 angeschlossen. Im unteren Bereich des Gestells 50 ist als zweites Ausführungsbeispiel das Kabel 13, 13' den in der Traverse 15 angeordneten Steckerbuchsen 14, 14' zugeführt. Bei diesem Ausführungsbeispiel werden die Geräteeinheiten 44, 45 mittels entsprechend angeordneter, nicht dargestellter Stecker in die Steckerbuchsen 14, 14' eingesteckt.

In Fig. 3 ist das Gestell 50 schematisch und im Schnitt gemäss der Linie III-III in Fig. 2 dargestellt und man erkennt die Rückwand 10 mit der Ausnehmung 3 und dem Hohlraum 10', den Rahmen 25, die Tür 41 sowie den Tragrahmen 8 mit den daraufliegenden und nach vorne geführten Kabeln 6, 6' und Steckern 7, 7'. Aus Gründen der besseren Übersicht ist die Geräteeinheit 47 in Fig. 3 nicht dargestellt.

In Fig. 4 ist schematisch und im Schnitt gemäss der Linie IV-IV in Fig. 2 das Gestell 50 dargestellt und man erkennt die Rückwand 10, den Rahmen 25, die Tür 41, die im Hohlraum 10' und im Bereich der Ausnehmung 3 der Rückwand 10 angeordnete Traverse 15 mit den Steckerbuchsen 14, 14' sowie die in nicht näher dargestellter Weise angeschlossenen Kabel 13, 13'. Aus Gründen der besseren Übersicht ist in Fig. 4 die Geräteeinheit 44 nicht dargestellt.

Bei dem anhand der Figuren 1 bis 4 beschriebenen Gestell 50 sind die Steckerorgane 5, 5' beispielsweise an der linken Seite der Rückwand 10 angeordnet. Die ankommenden Aussenleitungen 55, 56' sind mit in Fig. 3 und 4 schematisch dargestellten Schnellkupplungen 55, 56' in die einzelnen, übereinander angeordneten Steckerorgane 5, 5' einsteckbar.

Die Montage und Demontage des beschriebenen Gestells 50 zur Aufnahme der Geräteeinheiten 44 bis 49 sind besonders einfach und der insbesondere auf die Grundfläche (Stellfläche) bezogene Raumbedarf ist hinsichtlich der bisher bekannt gewordenen Gestelle verhältnismässig gering. Durch die baukastenartige Ausbildung des Gestells 50 ist eine getrennte, mit relativ kurzen Distanzen von vorne optimal zugängliche Bestückung der Rückwand 10 sowie eine Überprüfung der in dem Hohlraum 10' angeordneten, nicht näher dargestellten Verdrahtung gewährleistet. Nach der Beschickung und Überprüfung wird der Rahmen 25 an der Stirnseite der Rückwand 10 mit nicht dargestellten Mitteln zentriert und befestigt.

In zusammengebautem Zustand der beiden Baueinheiten 20, 35 sind die im wesentlichen aus den einzelnen Tragrahmen 8, 8' mit den daraufliegenden Kabeln 6, 6' gebildeten Verdrahtungsebenen zwischen den einzelnen, für den Einschub der Geräteeinheiten 44 bis 49 (Fig. 2) vorgesehenen Gleitschienen 28 angeordnet. Die einzelnen Tragrahmen 8, 8' sind im vorderen Bereich vorzugsweise je mit zwei Laschen 17 (Fig. 1) ausgestattet, welche zur stabilisierenden Befestigung der Tragrahmen 8, 8' an der vorderen Tragleiste 29 des Rahmens 25 dienen.

An dieser Stelle sei darauf hingewiesen, dass die mit 28 bezeichneten Elemente sowohl als Gleitschienen und/oder als Auszugsschienen ausgebildet sein können.

Zur Kontrolle der im Gestell 50 angeordneten elektronischen Geräteeinheiten ist die Tür 41 mit einer ein Fenster aufweisenden Klappe 42 ausgestattet.

Das beschriebene Gestell 50 ist vorzugsweise in Leichtbauweise hergestellt, wobei die einzelnen Baueinheiten 20, 35 und 40 als Aluminium-Schweisskonstruktion ausgebildet sind. Durch verschiedene Ventilatoren - in Fig. 1 sind beispielsweise zwei Ventilatoren 4, 4' dargestellt- und durch entsprechend angeordnete, nicht näher dargestellte Öffnungen ist eine ausreichende Wärmeabfuhr und Belüftung des Gestells 50 gewährleistet. Die an der Rückwand 10 sowie am Rahmen 25 angeordneten Schwingelemente 2 und 32 verhindern weitgehend eine Übertragung von Stössen und Vibrationen.

Das erfindungsgemässe Bausystem des Gestells 50 mit den wesentlichen, hinsichtlich der Verdrahtung und Bestückung getrennt ausgebildeten Bauteilen 20 und 35 (Rückwand 10 und Rahmen 25) ermöglicht gegenüber den bekannten Bausystemen eine einfache Montage und Demontage. Durch die seitlich, in montiertem Zustand der Bauteile 20 und 35 weitgehend freiliegend neben der Seitenwand 26 des Rahmens 25 angeordneten Steckerorgane 5, 5' (Fig. 3, 4), wurde die erforderliche Aufstellfläche (Grundfläche) des Gestells 50 wesentlich reduziert. Die Anordnung der Steckerorgane 5, 5' gewährleistet ferner ein einfaches, von vorne gut zugängliches Zuführen und Anschliessen der Aussenleitungen 55, 55', welche sowohl von der Decke als auch vom Boden zuführbar sind. Das erfindungsgemässe Bausystem des Gestells 50 eignet sich insbesondere für enge Raumverhältnisse, wie sie beispielsweise im allgemeinen Schiffsbau, insbesondere aber im militärischen Schiffsbau gegeben sind.

**Patentansprüche**

1. Bausystem für ein gehäuseartig ausgebildetes Gestell (50) der Vertikalbauweise zur Aufnahme elektronischer Geräteeinheiten (44, 45, 46, 47, 48, 49) die in übereinanderliegenden Verdrahtungsebenen über Stecker (7, 7'; 14, 14') mit entsprechend zugeführten, verkabelten Aussenleitungen (55, 55') der Nachrichten- und anderen Signal- und Stromversorgung verbindbar sind, dadurch gekennzeichnet, dass das Gestell (50) baukastenartig aus einer Rückwand (10) als erste Baueinheit (20) und einem Rahmen (25) als zweite Baueinheit (35) aufgebaut ist, wobei

- die Rückwand (10) kastenartig und zur Aufnahme der Verdrahtung mit einem Hohlraum (10') ausgebildet ist, auf der dem Rahmen (25) zugewandten Stirnseite mit einer Ausnehmung (3) weitgehend offen gestaltet und in den einzelnen Verdrahtungsebenen mit je einem Trägerorgan (8, 8'; 15) für das mit Steckern (7, 7'; 14, 14') versehene Kabel (6, 6'; 13, 13') und neben der Ausnehmung (3) für den Anschluss der Aussenleitungen (55, 55') mit Steckerorganen (5, 5') versehen ist,

- der Rahmen (25) an der Stirnseite der Rückwand (10) lösbar befestigt ist und innenseitig mehrere Gleit- und/oder Auszugsschienen (28) für die Geräteeinheiten (44 bis 49) aufweist, und

- in zusammengebautem Zustand der beiden Baueinheiten (20, 35) die Steckerorgane (5, 5') stirnseitig frei zugänglich an der Rückwand (10) des Gestells (50) angeordnet sind.

2. Bausystem nach Anspruch 1, dadurch gekennzeichnet, dass das Trägerorgan (8, 8') rahmenartig ausgebildet ist und zur Führung der Kabel (6, 6') seitlich angeordnete Kanäle (9, 9') aufweist.

3. Bausystem nach Anspruch 1 und 2, dadurch gekennzeichnet, dass in zusammengebautem Zustand der beiden Baueinheiten (20, 35) das einzelne Trägerorgan (8, 8') zwischen zwei Gleitschienen (28) angeordnet und an vorderen Tragleisten (29) des Rahmens (25) befestigbar ist.

4. Bausystem nach Anspruch 1, dadurch gekennzeichnet, dass das Trägerorgan als eine an Tragleisten (11, 11') der Rückwand (10) befestigbare Traverse (15) ausgebildet ist, welche zum Anschluss der Kabel (13, 13') mindestens zwei im Abstand zueinander angeordnete Steckerbuchsen (14, 14') aufweist.

5. Bausystem nach Anspruch 1, dadurch gekennzeichnet, dass die Steckerorgane (5, 5') stirnseitig an der linken oder rechten Seite der Rückwand (10) in vertikaler Richtung übereinanderliegend angeordnet sind.

6. Bausystem nach Anspruch 1, dadurch gekennzeichnet, dass die Rückwand (10), der Rahmen (25) sowie die Tür (41) des Gestells (50) in Leichtbauweise als Aluminium-Schweisskonstruktion ausgebildet sind.

**Claims**

1. Construction system for a rack (50) designed as a housing of the vertical construction type for the accommodation of electronic equipment units (44, 45, 46, 48, 49) which may be connected in superimposed wiring planes by way of connectors (7, 7'; 14, 14') with correspondingly supplied external cable lines (55, 55') for message and other signal and current supply, characterised in that the rack (50) is constructed, as a unitized construction, of a rear wall (10) as a first constructional unit (20), and a frame (25) as a second constructional unit (35), in which case
- the rear wall (10) is designed as a box and with a cavity (10') for the accommodation of the wiring, is shaped on the front side facing the frame (25) with a recess (3) so that for the most part it is open, and is provided in the individual wiring planes with, in each case, a support part (8, 8'; 15) for the cable (6, 6'; 13, 13') provided with connectors (7, 7'; 14, 14'), and next to the recess (3) is provided with connector parts (5, 5') for the connection of the external lines (55, 55')
- the frame (25) is secured detachably to the front side of the rear wall (10) and on the inside has several sliding and/or draw-out rails (28) for the equipment units (44 to 49) and
- the connector parts (5, 5') are arranged on the rear wall (10) of the rack (50) on the front side thereof so that they are freely accessible in the assembled state of the two constructional units (20, 35).

2. Construction system according to claim 1, characterised in that the support part (8, 8') is designed as a frame and has laterally arranged channels (9, 9') for the guidance of the cables (6, 6').

3. Construction system according to claim 1 and 2, characterised in that in the assembled state of the two constructional units (20, 35) the individual support part (8, 8') is arranged between two sliding rails (28) and may be secured to front supporting strips (29) of the frame (25).

4. Construction system according to claim 1, characterised in that the support part is designed as a cross-member (15) which may be secured to supporting strips (11, 11') of the rear wall (10) and has, for the connection of the cables (13, 13'), at least two connector sockets (14, 14') arranged at a distance from each other.

5. Construction system according to claim 1, characterised in that the connector parts (5, 5') are arranged on the front side on the left-or righthand side of the rear wall (10) so that they are superimposed in a vertical direction.

6. Construction system according to claim 1, characterised in that the rear wall (10), the frame (25) and also the door (41) of the rack (50) are designed as a welded aluminium structure in the manner of a lightweight construction.

## Revendications

1. Système de construction pour un bâti (50) en forme de boîtier en construction verticale pour recevoir des modules d'appareils électroniques (44, 45, 46, 47, 48, 49) qui peuvent être reliés par des câbles de transmission d'informations et d'autres signaux ainsi que des câbles d'alimentation placés dans des plans de câblage superposés, par l'intermédiaire de connecteurs (7, 7'; 14, 14') pour être reliés à des conducteurs extérieurs (55, 55'), caractérisé en ce que le bâti (50) est réalisé en forme de jeu de construction a partir d'un premier composant (20) constitué par une paroi arrière (10) et d'un second composant (35) constitué par un châssis (25),
- la paroi arrière (10) étant en forme de caisson pour recevoir le câblage dans une cavité (10'), et sur la face frontale de cette paroi, tournée vers le châssis (25), il est prévu une découpe (3) trés largement ouverte et dans les différents plans de câblage, il y a chaque fois un organe de support (8, 8'; 15) pour le câble (6, 6'; 13, 13') muni de connecteurs (7, 7'; 14, 14'), à côté de la découpe (3) il y a des organes de connexion (5, 5') pour le branchement des conducteurs extérieurs (55, 55'),
- le châssis (25) est fixé de manière amovible sur la face frontale de la paroi arrière (10) et comporte intérieurement plusieurs rails de glissement et/ou extractibles (28) pour les modules d'appareils (44 ... 49) et,
- lorsque les deux composants (20, 35) sont à l'état monté, les organes de connexion (5, 5') sont montés librement accessibles par la face frontale sur la paroi arrière (10) du bâti (50).

2. Système de construction selon la revendication 1, caractérisé en ce que l'organe de support (8, 8') est em forme de châssis et comporte des canaux latéraux (9, 9') pour le passage des câbles (6, 6').

3. Système de construction selon les revendications 1 et 2, caractérisé en ce que lorsque les deux composants (20, 35) sont à l'état monté, l'organe de support distinct (8, 8') est situé entre les deux rails de glissement (28) et est fixé aux longerons de support (29) avant du châssis (25).

4. Système de construction selon la revendication 1, caractérisé en ce que l'organe de support est en forme de traverse (15) susceptible d'être fixé sur un longeron de support (11, 11') de la paroi arrière (10), cette traverse comportant au moins deux connecteurs femelles (14, 14') à une certaine distance l'un de l'autre pour le branchement des câbles (13, 13').

5. Système de construction selon la revendication 1, caractérisé en ce que les organes de connexion (5, 5') sont montés frontalement sur le côté gauche ou le côté droit de la paroi arrière (10), de manière superposée dans la direction verticale.

6. Système de construction selon la revendication 1, caractérisé en ce que la paroi arrière (10), le châssis (20) ainsi que la porte (41) du bâti (50) sont réalisés en construction légère comme construction en aluminium soudé.

FIG. 1

FIG. 2

FIG. 3

FIG. 4